# EUROPÄISCHE PATENTSCHRIFT

(11) **EP 2 876 697 B1**
(45) Veröffentlichungstag und Bekanntmachung des Hinweises auf die Patenterteilung: **10.01.2018**
(21) Anmeldenummer: 14191580.1
(22) Anmeldetag: 04.11.2014
(51) Int. Cl.: H01L 35/00, H01L 35/30, H01L 35/32, H01L 23/34

(54) **Elektronisches Modul, Verfahren zum Betreiben eines solchen elektronischen Moduls und Verfahren zum Herstellen eines solchen elektronischen Moduls**
Electronic module, method for operating same and method for producing such an electronic module
Module électronique, procédé de fonctionnement d'un tel module électronique et procédé de fabrication d'un tel module électronique

(30) Priorität: 26.11.2013 DE 102013224068
(43) Veröffentlichungstag der Anmeldung: 27.05.2015
(73) Patentinhaber: ROBERT BOSCH GMBH, 70442 Stuttgart (DE)
(72) Erfinder: Pirk, Tjalf, 70195 Stuttgart (DE); Ehrenpfordt, Ricardo, 70825 Korntal-Muenchingen (DE); Ante, Frederik, 70197 Stuttgart (DE); Kenntner, Johannes, 70825 Korntal-Muenchingen (DE)

(56) Entgegenhaltungen:
- EP-A1- 2 320 383
- WO-A1-00/05769
- US-A1- 2007 039 332
- US-A1- 2009 000 309
- US-A1- 2012 312 345
- US-A1- 2013 192 655

## Beschreibung

### Stand der Technik

Die vorliegende Erfindung bezieht sich auf ein elektronisches Modul, auf ein Verfahren zum Betreiben eines solchen elektronischen Moduls, auf ein Verfahren zum Herstellen eines solchen elektronischen Moduls sowie auf ein entsprechendes Computerprogrammprodukt.

Das sogenannte Internet der Dinge, englisch Internet of Things oder IoT genannt, kann als eine der wichtigsten zukünftigen Entwicklungen im Bereich der Informationstechnologie bezeichnet werden. Mittels des Internets der Dinge ist es möglich, dass nicht nur Menschen Zugang zum Internet haben und über dieses vernetzt sind, sondern auch Geräte über das Internet miteinander vernetzt sind.

Ein Bereich des Internets der Dinge betrifft die Produktions- und Hausautomatisierung wie beispielsweise die Temperaturmessung. Entsprechende Sensoren wie etwa Temperatursensoren an Heizungen mit Niedrigenergie-Funktechnologie sind bereits verfügbar.

Beispielsweise können Erfahrungen bezüglich im Bereich der Unterhaltungselektronik, insbesondere in Smartphones, eingesetzter Sensoren wie etwa Gyrosensoren, Beschleunigungssensoren, Drucksensoren oder Mikrofone genutzt werden, um kostengünstige Sensoren für unter einem Euro herzustellen. Solche Sensoren können ausgebildet sein, um eine benötigte elektrische Energie mittels sogenannter Energy Harvester ("Energiewandler") aus der Umwelt zu gewinnen. Klassische Harvester sind beispielsweise Fotovoltaikzellen zur Energiegewinnung aus Sonnenlicht oder thermoelektrische Generatoren zur Energiegewinnung aus einer Temperaturdifferenz, beispielsweise an einer Heizung.

Aus der US 2012/0312345 A1 ist ein thermoelektrisches Energiegewinnungssystem bekannt, das einen thermoelektrischen Generator und elektronische Bauelemente umfasst. Der thermoelektrische Generator erzeugt eine elektrische Spannung, wenn eine Temperaturdifferenz über ihm anliegt. Ein Gehäuse ist auf dem thermoelektrischen Generator angeordnet. Es umfasst einen Hohlraum, in dem elektronische Module angeordnet sind. Die elektronischen Module werden vom thermoelektrischen Generator mit Strom versorgt. Der Hohlraum wird von einer inneren Oberfläche des Gehäuses umschlossen. Eine Strahlungsabschirmung bedeckt zumindest einen Teil der inneren Oberfläche, sodass die Strahlungswärme des Hohlraums von der Wärme des Gehäuses getrennt ist.

### Offenbarung der Erfindung

Vor diesem Hintergrund werden mit dem hier vorgestellten Ansatz ein elektronisches Modul, ein Verfahren zum Betreiben eines solchen elektronischen Moduls, ein Verfahren zum Herstellen eines solchen elektronischen Moduls sowie schließlich ein entsprechendes Computerprogrammprodukt gemäß den Hauptansprüchen vorgestellt. Vorteilhafte Ausgestaltungen ergeben sich aus den jeweiligen Unteransprüchen und der nachfolgenden Beschreibung.
Der vorliegende Ansatz schafft ein elektronisches Modul mit folgenden Merkmalen:
einem Gehäuse, das zumindest eine erste thermische Leitung und zumindest eine zweite thermische Leitung aufweist, wobei die erste thermische Leitung zumindest teilweise entlang einer ersten Oberfläche des Gehäuses verläuft, um eine thermische Energie einer ersten Außenumgebung des Gehäuses aufzunehmen, wobei die zweite thermische Leitung zumindest teilweise entlang einer zweiten Oberfläche des Gehäuses verläuft, um eine thermische Energie einer von der ersten Außenumgebung thermisch getrennten zweiten Außenumgebung aufzunehmen;
zumindest einem elektronischen Bauelement; und
zumindest einer in und/oder an dem Gehäuse angeordnete Energieversorgungseinheit, die mit dem elektronischen Bauelement über Schaltkreise und mit der ersten thermischen Leitung und der zweiten thermischen Leitung verbunden ist und ausgebildet ist, um unter Verwendung der thermischen Energie der ersten Außenumgebung und der thermischen Energie der zweiten Außenumgebung eine elektrische Energie zu erzeugen, um das zumindest ein elektronische Bauelement zu betreiben.
Bei dem elektronischen Modul kann es sich beispielsweise um einen Verbund aus Leiterplatten handeln, wobei der Verbund von dem Gehäuse umgeben sein kann. Unter einer ersten thermischen Leitung und einer zweiten thermischen Leitung kann je eine thermisch leitfähige Leiterbahn aus Metall, beispielsweise aus Kupfer, verstanden werden. Unter einer ersten Oberfläche und einer zweiten Oberfläche des Gehäuses kann je ein äußerer Abschluss des Gehäuses verstanden werden. Das Gehäuse kann derart angeordnet sein, dass die erste Oberfläche mit einer ersten Außenumgebung des Gehäuses und die zweite Oberfläche mit einer zweiten Außenumgebung des Gehäuses Kontakt hat. Die erste Außenumgebung und die zweite Außenumgebung können thermisch und/oder mechanisch voneinander getrennt sein. Beispielsweise kann es sich bei der ersten Außenumgebung um einen Innenraum eines Gebäudes und bei der zweiten Außenumgebung um eine äußere Umgebung des Gebäudes handeln. Hierbei kann die erste Außenumgebung eine Temperatur aufweisen, die von einer Temperatur der zweiten Außenumgebung abweicht. In und/oder an dem Gehäuse kann zumindest eine Energieversorgungseinheit angeordnet sein, die über die erste und die zweite thermische Leitung mit der ersten und der zweiten Außenumgebung thermisch gekoppelt ist. Bei der Energieversorgungseinheit kann es sich beispielsweise um einen thermoelektrischen Generator handeln, der ausgebildet ist, um unter Verwendung einer Differenz zwischen der Temperatur der ersten Außenumgebung und der Temperatur der zweiten Außenumgebung eine elektrische Energie bereitzustellen. Die derart bereitgestellte elektrische Energie kann verwendet werden, um zumindest ein elektronisches Bauelement, das mit der Energieversorgungseinheit elektrisch leitfähig verbunden ist, zu betreiben. Bei dem elektronischen Bauelement kann es sich beispielsweise um einen Sensor oder eine Funkkomponente handeln.

Der hier vorgestellte Ansatz beruht auf der Erkenntnis, dass ein elektronisches Modul zumindest einen thermoelektrischen Generator als Energieversorgungseinheit aufweisen kann. Ein solcher thermoelektrischer Generator kann ausgebildet sein, um unter Verwendung einer Temperaturdifferenz zwischen zwei Außenflächen des Moduls elektrische Energie zu erzeugen. Vorteilhafterweise kann das Modul derart an einem Einbauort platziert werden, dass die Außenflächen thermischen Kontakt zu je einer anderen Umgebung des Moduls haben, wobei die Umgebungen zumindest thermisch voneinander getrennt sind. Dadurch kann eine konstante Temperaturdifferenz zwischen den Außenflächen erreicht werden, sodass elektronische Komponenten des Moduls zuverlässig und ressourcensparend mit Strom versorgt werden können. Ferner bietet ein solches elektronisches Modul den Vorteil einer besonders kosteneffizienten Herstellung.

Gemäß einer Ausführungsform des vorliegenden Ansatzes kann das Gehäuse derart ausgestaltet sein, dass die erste Oberfläche der zweiten Oberfläche gegenüberliegt. Beispielsweise kann das Gehäuse quaderförmig ausgeführt sein, wobei die erste Oberfläche einer Vorderseite und die zweite Oberfläche einer der Vorderseite gegenüberliegenden Rückseite des Gehäuses entspricht. Dadurch kann das Gehäuse sehr flexibel zwischen zwei thermisch und mechanisch voneinander getrennten Außenumgebungen platziert werden, wie beispielsweise in oder an einer Fensterscheibe.

Gemäß einer weiteren Ausführungsform des vorliegenden Ansatzes kann das elektronische Modul zumindest eine mit dem elektronischen Bauelement verbundene Fotovoltaikzelle umfassen, die derart in und/oder an dem Gehäuse angeordnet sein kann, dass die erste Oberfläche und/oder die zweite Oberfläche zumindest teilweise durch eine Oberfläche der Fotovoltaikzelle gebildet ist. Die Fotovoltaikzelle kann mit dem elektronischen Bauelement elektrisch leitfähig verbunden sein. Somit kann das elektronische Bauelement zusätzlich mit elektrischer Energie versorgt werden. Dadurch kann eine Zuverlässigkeit des elektronischen Moduls erhöht werden.

Ferner kann die erste thermische Leitung und/oder die zweite thermische Leitung zumindest teilweise zwischen der Fotovoltaikzelle und dem Gehäuse verlaufen. Beispielsweise kann die erste und/oder die zweite thermische Leitung derart entlang einer Rückseite der Fotovoltaikzelle geführt sein, dass zwischen die Fotovoltaikzelle mit der ersten und/oder der zweiten thermischen Leitung thermisch gekoppelt ist. Somit kann beispielsweise eine von der Fotovoltaikzelle aufgenommene Wärme zum Erzeugen der elektrischen Energie verwendet werden. Ferner kann dadurch eine kompakte Leitungsführung realisiert werden.

Des Weiteren kann das elektronische Modul ein Energiespeicherzellengehäuse zum Aufnehmen zumindest einer Energiespeicherzelle zur Energiebereitstellung zur Versorgung und/oder Unterstützung des elektronischen Bauelements aufweisen. Unter einem Energiespeicherzellengehäuse kann beispielsweise ein Batteriefach verstanden werden. Das Energiespeicherzellengehäuse kann beispielsweise wiederlösbar mit dem Gehäuse verbindbar sein. Unter einer Energiespeicherzelle kann beispielsweise eine Batterie oder ein Akkumulator, etwa in Form einer Knopfzelle, verstanden werden. Das Energiespeicherzellengehäuse kann elektrische Kontaktanschlüsse aufweisen, um die Energiespeicherzelle mit elektrischen Kontaktanschlüssen des Gehäuses elektrisch leitfähig zu verbinden. Die Energiespeicherzelle kann ähnlich wie die weiter oben beschriebene Fotovoltaikzelle verwendet werden, um das elektronische Bauelement zusätzlich mit elektrischer Energie zu versorgen. Dadurch kann eine konstante Stromversorgung des elektronischen Moduls und/oder des elektrischen Bauelements sichergestellt werden.

Das Energiespeicherzellengehäuse kann gemäß einer weiteren Ausführungsform des vorliegenden Ansatzes eine thermisch leitfähige Struktur zum Aufnehmen der thermischen Energie der ersten Außenumgebung und/oder der thermischen Energie der zweiten Außenumgebung aufweisen. Hierbei kann das Energiespeicherzellengehäuse derart an der ersten Oberfläche und/oder der zweiten Oberfläche des Gehäuses angeordnet oder anordenbar sein, dass die thermisch leitfähige Struktur mit der ersten thermischen Leitung und/oder der zweiten thermischen Leitung thermisch leitfähig verbunden ist. Unter einer thermisch leitfähigen Struktur kann eine Leiterbahn ähnlich der ersten oder der zweiten thermischen Leitung verstanden werden. Beispielsweise kann die thermisch leitfähige Struktur zumindest teilweise entlang einer Hauptoberfläche des Energiespeicherzellengehäuses verlaufen. Vorteilhafterweise kann das Energiespeicherzellengehäuse derart an dem Gehäuse angebracht werden, dass die Hauptoberfläche mit der ersten oder der zweiten Außenumgebung thermischen Kontakt hat.

Vorteilhafterweise kann das Energiespeicherzellengehäuse eine Antennenstruktur zum Vergrößern einer Länge einer in und/oder an dem Gehäuse angeordneten Funkkomponente, insbesondere einer Antenne, aufweisen. Unter einer Antennenstruktur können metallische Leiterbahnen zum Übertragen elektromagnetischer Wellen verstanden werden. Beispielsweise kann die Antennenstruktur derart an dem Energiespeicherzellengehäuse angeordnet sein, dass ein Teilbereich der Antennenstruktur Kontakt mit der ersten und/oder der zweiten Außenumgebung hat und ein weiterer Teilbereich der Antennenstruktur mit der Funkkomponente verbunden ist, sofern das Energiespeicherzellengehäuse an dem Gehäuse befestigt ist.

Gemäß einer weiteren Ausführungsform des vorliegenden Ansatzes kann das elektronische Bauelement als Sensorelement ausgebildet sein. Dadurch kann das elektronische Modul zur Sensierung verschiedener Eigenschaften einer Umgebung des elektronischen Moduls verwendet werden.

Das elektronische Bauelement kann zudem in einem Hohlraum des Gehäuses angeordnet oder anordenbar sein. Hierbei kann insbesondere zumindest ein Kanal in dem Gehäuse ausgebildet sein, um den Hohlraum mit der ersten Außenumgebung und/oder der zweiten Außenumgebung fluidisch zu verbinden. Dadurch kann das elektronische Bauelement vor mechanischen Belastungen und/oder Umwelteinflüssen geschützt in dem Gehäuse untergebracht werden und gleichzeitig eine fluidische Verbindung des elektronischen Bauelements mit einer Außenumgebung des Gehäuses hergestellt werden (Mediensensorik).

Ferner kann das Gehäuse derart in und/oder an einer Scheibe und/oder einem Rahmen eines Fensters oder einer Tür bzw. Wand angeordnet oder anordenbar sein, dass die erste Oberfläche des Gehäuses einer der ersten Außenumgebung zugewandten Hauptoberfläche des Fensters zugewandt ist und die zweite Oberfläche des Gehäuses einer der zweiten Außenumgebung zugewandten Hauptoberfläche des Fensters zugewandt ist. Das Fenster kann ausgebildet sein, um die erste und die zweite Außenumgebung thermisch und mechanisch voneinander zu trennen. Das Gehäuse kann beispielsweise in eine Aussparung der Scheibe oder des Rahmens eingebracht sein. Eine solcher Einbauort des Gehäuses bietet den Vorteil einer möglichst großen Temperaturdifferenz zwischen der ersten und der zweiten Außenumgebung.

Der vorliegende Ansatz schafft ferner ein Verfahren zum Betreiben eines elektronischen Moduls gemäß einer der vorangehend beschriebenen Ausführungsformen, wobei das Verfahren folgende Schritte umfasst:
Leiten einer thermischen Energie der ersten Außenumgebung über die erste thermische Leitung zu der Energieversorgungseinheit und einer thermischen Energie der zweiten Außenumgebung über die zweite thermische Leitung zu der Energieversorgungseinheit; und
Erzeugen einer elektrischen Energie unter Verwendung der thermischen Energie der ersten Außenumgebung und der thermischen Energie der zweiten Außenumgebung, um das elektronische Bauelement mit elektrischer Energie zu versorgen.

Schließlich schafft der hier vorgestellte Ansatz ein Verfahren zum Herstellen eines elektronischen Moduls gemäß einer der vorangehend beschriebenen Ausführungsformen, wobei das Verfahren folgende Schritte umfasst:
Bilden eines Gehäuses, das zumindest eine erste thermische Leitung und zumindest eine zweite thermische Leitung aufweist, wobei das Bilden derart erfolgt, dass die erste thermische Leitung zumindest teilweise entlang einer ersten Oberfläche des Gehäuses verläuft, um eine thermische Energie einer ersten Außenumgebung des Gehäuses aufzunehmen, und die zweite thermische Leitung zumindest teilweise entlang einer zweiten Oberfläche des Gehäuses verläuft, um eine thermische Energie einer von der ersten Außenumgebung thermisch getrennten zweiten Außenumgebung aufzunehmen; und
Anordnen zumindest eines elektronischen Bauelements und zumindest einer Energieversorgungseinheit in und/oder an dem Gehäuse, wobei das Anordnen derart erfolgt, dass die Energieversorgungseinheit mit dem elektronischen Bauelement, der ersten thermischen Leitung und der zweiten thermischen Leitung verbunden wird, wobei die Energieversorgungseinheit ausgebildet ist, um unter Verwendung der thermischen Energie der ersten Außenumgebung und der thermischen Energie der zweiten Außenumgebung eine elektrische Energie zu erzeugen, um das zumindest ein elektronische Bauelement zu betreiben.

Von Vorteil ist auch ein Computerprogrammprodukt mit Programmcode, der auf einem maschinenlesbaren Träger wie einem Halbleiterspeicher, einem Festplattenspeicher oder einem optischen Speicher gespeichert sein kann und zur Durchführung des Verfahrens nach einer der vorstehend beschriebenen Ausführungsformen verwendet wird, wenn das Programmprodukt auf einem Computer oder einer Vorrichtung ausgeführt wird.

Der hier vorgestellte Ansatz wird nachstehend anhand der beigefügten Zeichnungen beispielhaft näher erläutert. Es zeigen:
- Fig. 1: eine schematische Darstellung eines elektronischen Moduls gemäß einem Ausführungsbeispiel der vorliegenden Erfindung;
- Fig. 2: eine Querschnittsdarstellung eines elektronischen Moduls gemäß einem Ausführungsbeispiel der vorliegenden Erfindung;
- Fig. 3: eine Querschnittsdarstellung eines elektronischen Moduls gemäß einem Ausführungsbeispiel der vorliegenden Erfindung;
- Fig. 4: eine Querschnittsdarstellung eines elektronischen Moduls gemäß einem Ausführungsbeispiel der vorliegenden Erfindung;
- Fig. 5: eine Querschnittsdarstellung eines elektronischen Moduls gemäß einem Ausführungsbeispiel der vorliegenden Erfindung;
- Fig. 6: eine schematische Darstellung eines möglichen Einbauorts eines elektronischen Moduls gemäß einem Ausführungsbeispiel der vorliegenden Erfindung;
- Fig. 7: ein Ablaufdiagramm eines Ausführungsbeispiels eines Verfahrens zum Betreiben eines elektronischen Moduls; und
- Fig. 8: ein Ablaufdiagramm eines Ausführungsbeispiels eines Verfahrens zum Herstellen eines elektronischen Moduls.

In der nachfolgenden Beschreibung günstiger Ausführungsbeispiele der vorliegenden Erfindung werden für die in den verschiedenen Figuren dargestellten und ähnlich wirkenden Elemente gleiche oder ähnliche Bezugszeichen verwendet, wobei auf eine wiederholte Beschreibung dieser Elemente verzichtet wird.

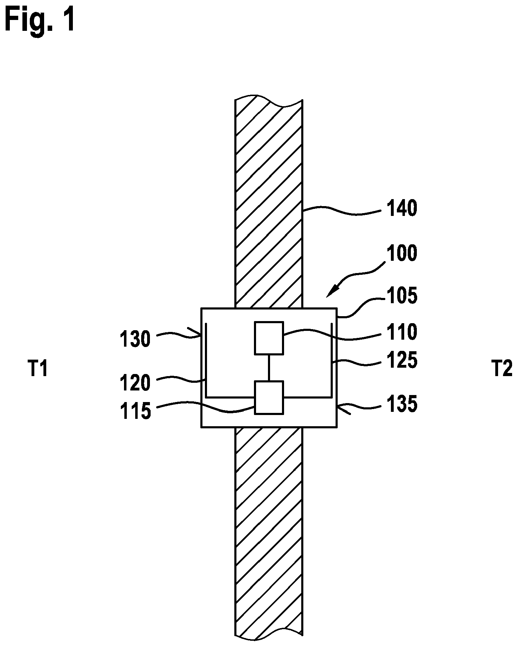

Fig. 1 zeigt eine schematische Darstellung eines elektronischen Moduls 100 gemäß einem Ausführungsbeispiel der vorliegenden Erfindung. Das elektronische Modul 100, auch elektronisches Bauteil 100 genannt, umfasst ein das elektronische Modul 100 umgebendes Gehäuse 105, in dem ein elektronisches Bauelement 110 und eine Energieversorgungseinheit 115 angeordnet sind. Das elektronische Bauelement 110 und die Energieversorgungseinheit 115 sind elektrisch über Schaltkreise (Leiterbahnen, Mikrocontroller, ASICS, Passiva) miteinander verbunden. Beispielsweise sind das elektronische Bauelement 110 und die Energieversorgungseinheit 115 als Komponentenverbund realisiert. Die Energieversorgungseinheit 115 ist ferner mit einer ersten thermischen Leitung 120 und einer zweiten thermischen Leitung 125 verbunden. Hierbei verläuft die erste thermische Leitung 120 entlang einer ersten Oberfläche 130 des Gehäuses 105 und die zweite thermische Leitung 125 entlang einer zweiten Oberfläche 135 des Gehäuses 105. Die erste Oberfläche 130 ist der zweiten Oberfläche 135 gegenüberliegend angeordnet. Die erste Oberfläche 130 kann auch als erster äußerer Abschluss 130 des Moduls 100 und die zweite Oberfläche 135 auch als zweiter äußerer Abschluss 135 des Moduls 100 bezeichnet werden.

Das elektronische Modul 100 ist in Fig. 1 beispielhaft in eine Trennwand 140 eingebaut, die eine mechanische und thermische Trennung zwischen einer ersten Umgebung T1 und einer zweiten Umgebung T2 des Moduls 100 ermöglicht. Hierbei ist das Gehäuse 105 derart in der Trennwand 140 angeordnet, dass die erste Oberfläche 130 der ersten Umgebung T1 und die zweite Oberfläche 135 der zweiten Umgebung T2 zugewandt ist. Somit hat das elektronische Modul 100 zumindest in Teilbereichen eine Anbindung zu zwei voneinander mechanisch und thermisch getrennten Umgebungen T1, T2.

Die erste thermische Leitung 120 ist ausgebildet, um eine thermische Energie der ersten Umgebung T1 aufzunehmen. Die zweite thermische Leitung 125 ist ausgebildet, um eine thermische Energie der zweiten Umgebung T2 aufzunehmen. Die Energieversorgungseinheit 115 ist ausgebildet, um unter Verwendung der thermischen Energie der ersten Umgebung T1 und der thermischen Energie der zweiten Umgebung T2 eine elektrische Energie zu erzeugen. Die erzeugte elektrische Energie kann verwendet werden, um das elektronische Bauelement 110 zu betreiben.

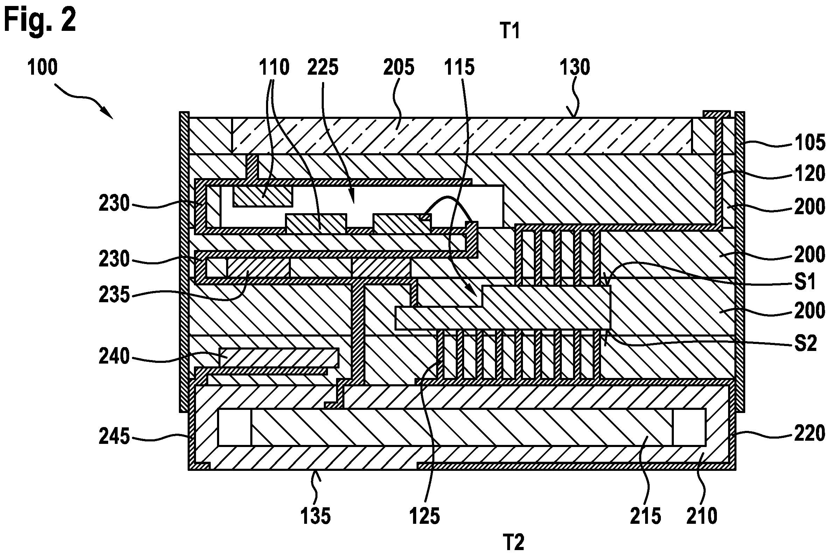

Fig. 2 zeigt eine Querschnittsdarstellung eines elektronischen Moduls 100 gemäß einem Ausführungsbeispiel der vorliegenden Erfindung. Das elektronische Modul 100 umfasst eine Mehrzahl elektrischer Leiterplatten 200. Die Leiterplatten 200, auch printed circuit board (PCB) genannt, bilden hierbei einen mechanisch festen Verbund, der beispielsweise durch Leiterplattentechnologien wie Verpressen von Epoxidlagen, galvanisches Schichtwachstum, Strukturierungsverfahren wie Fräsen, Lasern, Ätzen oder Durchkontaktierungstechnologien erzeugt werden kann. Der Verbund ist von dem Bauteilgehäuse 105 umgeben.

In eine äußerste der Leiterplatten 200 ist eine fotovoltaische Solarzelle 205 derart eingebracht, dass der erste äußere Abschluss 130 durch eine aktive Seite der Fotovoltaikzelle 205 gebildet ist. Beispielsweise kann die Fotovoltaikzelle 205 mittels Embedding-Technologie in die Leiterplatte 200 eingebaut werden.

Das elektronische Modul 100 ist mit einem thermoelektrischen Generator als Energieversorgungseinheit 115 realisiert. Eine der Fotovoltaikzelle 205 zugewandte Seite S1 des thermoelektrischen Generators 115 ist über thermische Leitungspfade der ersten thermischen Leitung 120 mit der Umgebung T1 verbunden. Hierbei ist die erste thermische Leitung 120 seitlich an der Fotovoltaikzelle 205 vorbeigeführt, um eine thermische Verbindung zum ersten äußeren Abschluss 130 herzustellen, der im Bereich der aktiven Seite der Fotovoltaikzelle 205 ausgeprägt ist. Eine der Seite S1 gegenüberliegende Seite S2 des thermoelektrischen Generators 115 ist über thermische Leitungspfade der zweiten thermischen Leitung 125 mit der Umgebung T2 verbunden. Hierbei verläuft ein Teilabschnitt der zweiten thermischen Leitung 125 entlang des zweiten äußeren Abschlusses 135.

Des Weiteren umfasst das elektronische Modul 100 ein Energiespeicherzellengehäuse 210, auch Wechselelement 210 genannt. In dem Energiespeicherzellengehäuse 210 ist eine Energiespeicherzelle 215 angeordnet, beispielsweise eine wechselbare Batterie oder ein Akku in Form einer Knopfzelle. Das Energiespeicherzellengehäuse 210 ist mit einer den zweiten äußeren Abschluss 135 bildenden Seite des Gehäuses 105 wiederlösbar verbunden.

Das Energiespeicherzellengehäuse 210 ist mit einer thermisch leitfähigen Struktur 220 ausgeführt, die derart ausgebildet ist, dass beim Anbringen des Energiespeicherzellengehäuses 210 an dem Gehäuse 105 die zweite thermische Leitung 135 mit der thermisch leitfähigen Struktur 220 thermisch gekoppelt wird. Hierbei verläuft ein Teilabschnitt der thermisch leitfähigen Struktur 220 entlang einer der Umgebung T2 zugewandten Hauptoberfläche des Energiespeicherzellengehäuses 210. Der zweite äußere Abschluss 135 ist also durch die Hauptoberfläche gebildet, sofern das Energiespeicherzellengehäuse 210 mit dem Gehäuse 105 verbunden ist. Die Seite S2 des thermoelektrischen Generators 115 ist mittels der thermisch leitfähigen Struktur 220 und der zweiten thermischen Leitung 125 derart mit der Hauptoberfläche verbunden, dass die Seite S2 eine Temperatur der Hauptoberfläche annimmt.

In einem Hohlraum 225 des elektronischen Moduls 100 sind beispielhaft drei Sensoren als elektronische Bauelemente 110 angeordnet. Die Sensoren 110 sind über Leiterbahnen 230 mit der Fotovoltaikzelle 205, dem thermoelektrischen Generator 115, der Energiespeicherzelle 215 sowie beispielhaft mit zwei Anwendungsspezifischen integrierten Schaltungen 235, kurz ASIC genannt, elektrisch leitfähig verbunden. Die Energiespeicherzelle 215 und die Fotovoltaikzelle 205 dienen somit als zusätzliche Stromquellen für die Sensoren 110.

Beispielsweise können mikromechanische Sensoren 110, auch MEMS-Sensoren genannt, sowie weitere Elektroniken oder passive Bauteile in den Epoxidlagen eingepresst oder in Hohlräumen 225 des Moduls 100 eingeklebt sein. Die elektrischen Kontaktierungen der Bauteile können beispielsweise mittels Durchkontaktierungstechnologien wie Lasern von Löchern, Laserstopp auf Kupfer und Metallisierung der Löcher, mittels Flip-Chip-Technologien oder durch Drahtbonden erzeugt werden. Die thermischen Leitungen 120, 125 sind beispielsweise als metallische Durchkontakte oder metallische Inserts realisiert.

Gemäß einem Ausführungsbeispiel der vorliegenden Erfindung ist das elektronische Modul 100 mit einem Funkchip 240 und einer Antennenstruktur 245 zur kabellosen Kommunikation ausgestattet. Die Antennenstruktur 245 umfasst elektrische Leiterbahnen, die beispielsweise aus Kupfer gefertigt sind. Ein Teilabschnitt der Antennenstruktur 245 verläuft beispielhaft entlang einer Außenfläche einer Seitenwand des Energiespeicherzellengehäuses 210. Ein weiterer Teilabschnitt der Antennenstruktur 245 verläuft innerhalb des Gehäuses 105. Hierbei ist der weitere Teilabschnitt mit dem Funkchip 240 elektrisch leitfähig verbunden. Der Teilabschnitt ist mit dem weiteren Teilabschnitt verbunden, sofern das Energiespeicherzellengehäuse 210 wie in Fig. 2 an dem Gehäuse 105 angebracht ist.

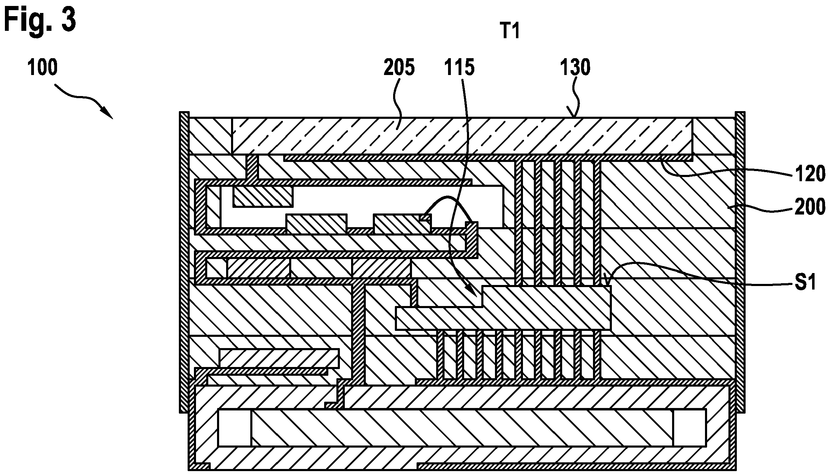

Fig. 3 zeigt eine Querschnittsdarstellung eines elektronischen Moduls 100 gemäß einem Ausführungsbeispiel der vorliegenden Erfindung. Statt wie in Fig. 2 seitlich an der Fotovoltaikzelle 205 vorbeizuführen, verläuft die erste thermische Leitung 120 in Fig. 3 entlang eines Großteils einer Solarzellenrückseite der Fotovoltaikzelle 205. Hierbei ist ein Teilabschnitt der ersten thermischen Leitung 120 zwischen der Fotovoltaikzelle 205 und einer der Solarzellenrückseite benachbarten Leiterplatte 200 angeordnet, sodass die erste thermische Leitung 120 mit der Solarzellenrückseite thermisch gekoppelt ist. Die Solarzellenrückseite steht mit der Umgebung T1 in Verbindung. Dadurch wird erreicht, dass die Seite S1 des thermoelektrischen Generators 115 eine Temperatur der Solarzellenrückseite annimmt.

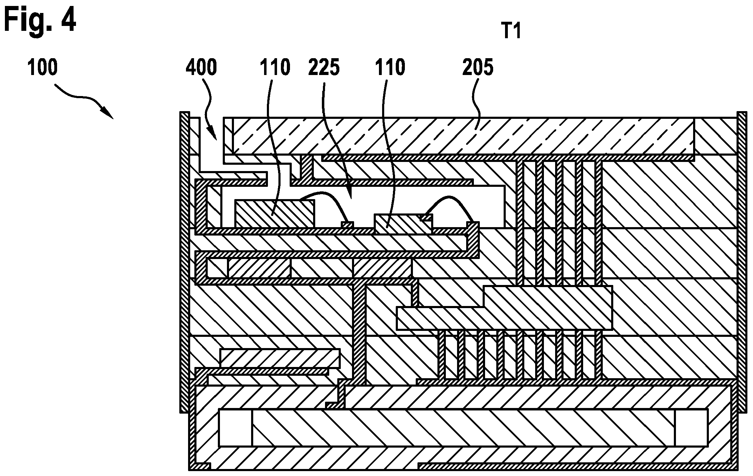

Fig. 4 zeigt eine Querschnittsdarstellung eines elektronischen Moduls 100 gemäß einem Ausführungsbeispiel der vorliegenden Erfindung. Im Unterschied zu Fig. 3 umfasst das in Fig. 4 gezeigte elektronische Modul 100 einen Medienzugang mit einem fluidischen Kanal 400, der ausgebildet ist, um eine fluidische Verbindung zwischen der Umgebung T1 und sensitiven Bereichen der Sensoren 110, die in dem Hohlraum 225 des Verbunds eingebracht sind, herzustellen. Hierbei ist der fluidische Kanal 400 seitlich an der Fotovoltaikzelle 205 vorbeigeführt. In Fig. 4 sind beispielhaft zwei statt drei Sensoren 110 gezeigt. Somit ist es beispielsweise möglich, Drucksensoren, Gassensoren, Feuchtesensoren oder Mikrofone als Sensoren 110 zu verwenden und mit den Umgebungen T1, T2 an den äußeren Abschlüssen 130, 135 des elektronischen Bauteils 100 zu verbinden.

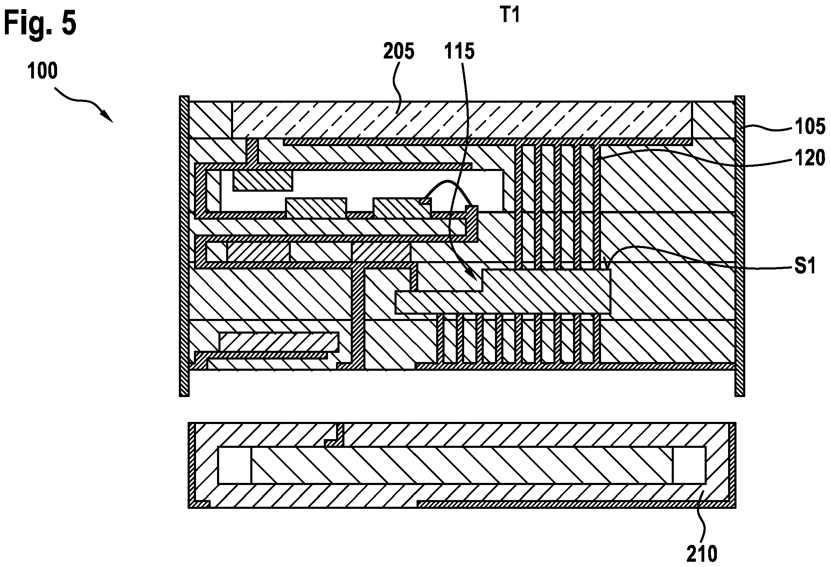

Fig. 5 zeigt eine Querschnittsdarstellung eines elektronischen Moduls 100 gemäß einem Ausführungsbeispiel der vorliegenden Erfindung. Im Unterschied zu den Figuren 2 und 3 ist das Wechselelement 210 in Fig. 5 von dem Gehäuse 105 getrennt. Beispielsweise kann das Wechselelement 210 vom Verbund des elektronischen Bauteils 100 mechanisch und elektrisch getrennt werden, um einen Batteriewechsel durchzuführen. Eine mechanische Arretierung des Wechselelements 210 kann etwa durch ein Gewinde oder eine Steckverbindung realisiert sein. Eine elektrische Kontaktierung zwischen dem Wechselelement 210 und dem Gehäuse 105 kann beispielsweise durch Steck-, Stift- oder Presskontakte realisiert sein.

Ferner ist die erste thermische Leitung 120 im Gegensatz zu den Figuren 2 bis 4 derart ausgeführt, dass sie sowohl entlang der Solarzellenrückseite verläuft, wie in den Figuren 3 und 4 gezeigt, als auch seitlich an der Fotovoltaikzelle 205 vorbeiführt, wie in Fig. 2 gezeigt, um eine thermische Verbindung zwischen der Seite S1 des thermoelektrischen Generators 115 und der Umgebung T1 herzustellen.

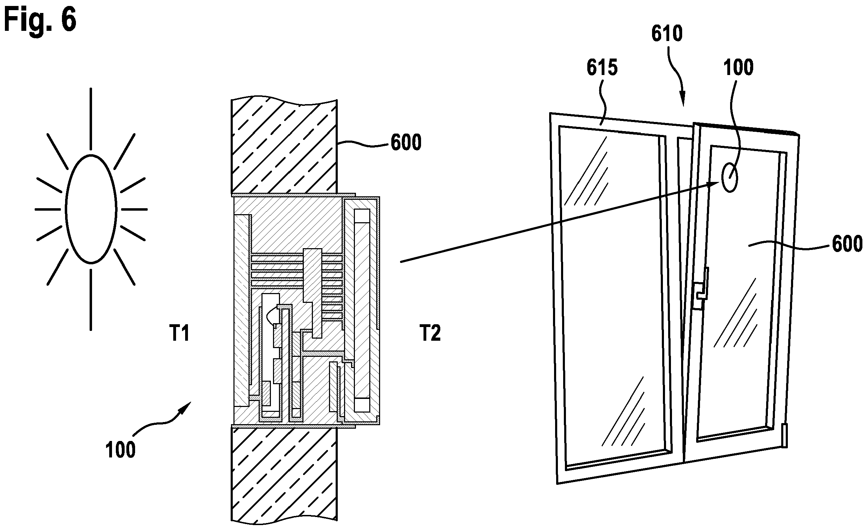

Fig. 6 zeigt eine schematische Darstellung eines möglichen Einbauorts eines elektronischen Moduls 100 gemäß einem Ausführungsbeispiel der vorliegenden Erfindung. Bei dem in Fig. 6 gezeigten Modul 100 handelt es sich beispielsweise um das in Fig. 5 gezeigte Modul. Das Modul 100 ist in eine Fensterscheibe 600 eines Fensters 610 eingebaut. Alternativ kann das Modul 100 in einen Fensterrahmen 615 des Fensters 610 eingebaut sein oder an einer Innen- oder Außenseite der Fensterscheibe 600 oder des Fensterrahmens 615 befestigt sein. Das Fenster 610 ist ausgebildet, um die Umgebung T1 und die Umgebung T2 thermisch und mechanisch voneinander zu trennen. Bei der Umgebung T1 handelt es sich beispielsweise um eine durch Jahreszeiten, einen Tag-Nacht-Rhythmus und eine Wetterlage bestimmte Umwelt eines Gebäudes. Bei der Umgebung T2 handelt es sich beispielsweise um einen Innenraum des Gebäudes. Das Modul 100 ist derart in die Fensterscheibe 600 eingebaut, dass die aktive Seite der Fotovoltaikzelle 205, die den ersten äußeren Abschluss 130 des Moduls 100 bildet, der Umgebung T1 zugewandt ist und das Energiespeicherzellengehäuse 210, das den zweiten äußeren Abschluss 135 des Moduls 100 bildet, der Umgebung T2 zugewandt ist.

In Fig. 6 ist beispielhaft eine von mehreren möglichen Applikationen eines Ausführungsbeispiels der vorliegenden Erfindung dargestellt. Im Allgemeinen kann das elektronische Modul 100 überall dort Anwendung finden, wo Temperaturgradienten auftreten und zwei Umgebungen T1, T2 mit einem zumindest zeitweise vorhandenen Temperaturgradienten vorliegen bzw. vorteilhafterweise mechanisch und elektrisch voneinander getrennt sind und Zustandsgrößen eines Einbauorts oder einer Umgebung des Moduls 100 kabellos detektiert werden sollen.

Im Folgenden wird ein Ausführungsbeispiel der vorliegenden Erfindung anhand der Figuren 2 bis 6 beschrieben.

Ein elektronisches Sensorbauteil 100 ist mit einer thermoelektrischen Energieversorgung 115 ausgeführt. Das Sensorbauteil 100 ist ausgebildet, um eine Sensorik für ein Monitoring bestimmter Zustandsgrößen mit einer autonomen Energieversorgung unter Nutzung eines Temperaturgradienten zwischen Gebäudeinnenräumen und einer umgebenden Außentemperatur zu kombinieren.

Hierzu umfasst das elektronische Bauteil 100 ein das elektronische Bauteil 100 zumindest teilweise umgebendes Bauteilgehäuse 105, ein thermoelektrisches Bauelement 115, das ausgebildet ist, um thermische Energie in elektrische Energie zu wandeln, sowie thermische Leitungspfade als thermische Leitungen 120, 125 und elektrische Leitungspfade 230. Das elektronische Bauteil 100 ist ausgebildet, um eine Anbindung zu zwei voneinander mechanisch und thermisch getrennten Umgebungen T1, T2 derart herzustellen, dass die thermische Energie der beiden Umgebungen T1, T2 über die thermischen Leitungspfade 120, 125 getrennt voneinander zum thermoelektrischen Bauelement 115 geführt wird. Das thermoelektrische Bauelement 115 ist ausgebildet, um aus einem Temperaturunterschied zwischen den beiden Umgebungen T1, T2 eine elektrische Energie zu generieren, die zu weiteren elektronischen Komponenten des elektronischen Bauteils 100 über die elektrischen Leitungspfade 230 geführt wird.

Hierbei reicht das Bauteilgehäuse 105 zumindest teilweise in beide Umgebungen T1, T2 und/oder von der Umgebung T1 in die Umgebung T2.

Des Weiteren weist das elektronische Bauteil 100 an einem seiner äußeren Abschlüsse 130, 135 eine fotovoltaische Komponente 205 auf.

Die thermischen Leitungspfade sind beispielsweise ausgebildet, um als erste thermische Leitung 120 ausgehend von einer Seite S1 des thermoelektrischen Bauelements 115 das fotovoltaische Bauelement 205 thermisch zu kontaktieren.

Alternativ oder zusätzlich sind die thermischen Leitungspfade derart ausgestaltet, dass sie als erste thermische Leitung 120 an dem fotovoltaischen Bauelement 205 vorbeiführen und mit diesem einen äußeren Abschluss 130 des Bauteils 100 bilden, sodass ein thermischer Kontakt zwischen den thermischen Leitungspfaden und der Umgebung T1 des elektronischen Bauteils 100 besteht.

Ferner kann das elektronische Bauteil 100 an einem der äußeren Abschlüsse 130, 135 ein Wechselelement 210 aufweisen, das ausgebildet ist, um auf das Bauteilgehäuse 105 aufgebracht, beispielsweise aufgedreht oder aufgesteckt zu werden und/oder von dem Bauteilgehäuse 105 abgenommen zu werden. Beispielsweise ist das Wechselelement 210 als abnehmbares Deckelelement ausgeführt. Das Wechselelement 210 ist ausgebildet, um einen Energiespeicher 215, etwa eine Batterie oder einen Akku, aufzunehmen. Ferner verfügt das Wechselelement 210 über Anschlusskontakte, die eine elektrische Verbindung des Energiespeichers 215 mit weiteren Komponenten des elektronischen Bauteils 100 ermöglichen.

Die thermischen Leitungspfade können, ausgehend von einer Seite S2 des thermoelektrischen Bauelements 115, als zweite thermische Leitung 125 derart durch das Wechselelement 210 hindurch- und/oder an diesem vorbeigeführt sein, dass sie an ihrem Ende einen gemeinsamen Abschluss mit dem Wechselelement 210 bilden. Somit wird ein thermischer Kontakt zwischen der Umgebung T2 und den thermischen Leitungspfaden hergestellt.

Das elektronische Bauteil 100 kann zumindest eine Funkkomponente 240 umfassen, die ausgebildet ist, um Daten kabellos zu senden und/oder zu empfangen.

Zum Senden und/oder Empfangen der Daten kann das elektronische Bauteil 100 Antennenstrukturen 245 aufweisen, die zu zumindest einem der beiden äußeren Abschlüsse 130, 135 reichen.

Das elektronische Bauteil 100 kann Sensoren 110 umfassen, die ausgebildet sind, um eine Lage und/oder eine Position eines Einbauorts des elektronischen Bauteils 100 zu erfassen. Hierbei kann das Bauteilgehäuse 105 mit dem Einbauort mechanisch fest verbunden sein.

Die Sensoren 110 können sensitive Bereiche aufweisen, die mit zumindest einer der beiden Umgebungen T1, T2 an den äußeren Abschlüssen 130, 135 des elektronischen Bauteils 100 fluidisch verbunden sind.

Die Sensoren 110 sind beispielsweise als MEMS-Sensoren realisiert (MEMS = micro-electro-mechanical systems; "mikroelektromechanische Systeme"). Ferner sind die Sensoren 110 beispielsweise als Beschleunigungs-, Drehraten-, Hall-, Magnet-, Druck-, Temperatur-, Gassensoren oder Mikrofone realisiert.

Die Komponenten des elektronischen Bauteils 100 können einen mechanisch festen Verbund bilden, der beispielsweise von dem Bauteilgehäuse 105 umgeben ist.

Schließlich kann das elektronische Bauteil 100 im Glas eines Fensters 610 oder in einem das Fenster 610 umgebenden Rahmen 615 eingelassen oder eingebracht sein und an einen Innenraum eines Gebäudes mit dem Fenster 610 sowie eine Außenumgebung des Gebäudes angebunden sein.

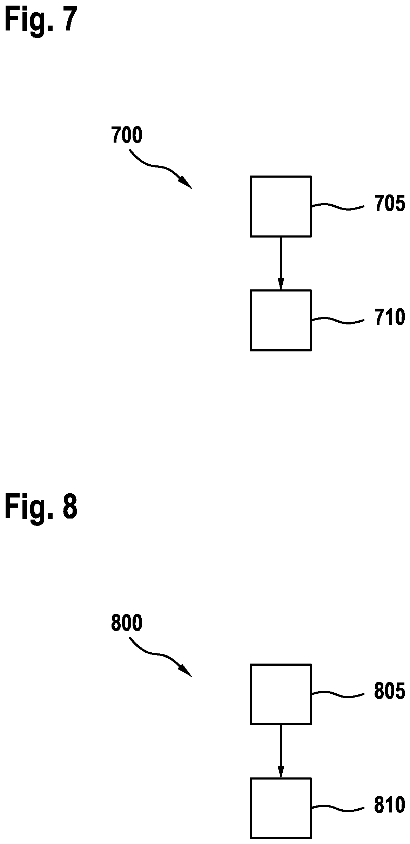

Fig. 7 zeigt ein Ablaufdiagramm eines Ausführungsbeispiels eines Verfahrens 700 zum Betreiben eines elektronischen Moduls. Zunächst erfolgt ein Schritt 705 des Leitens einer thermischen Energie der ersten Außenumgebung über die erste thermische Leitung zu der Energieversorgungseinheit und einer thermischen Energie der zweiten Außenumgebung über die zweite thermische Leitung zu der Energieversorgungseinheit.

In einem weiteren Schritt 710 wird unter Verwendung der thermischen Energie der ersten Außenumgebung und der thermischen Energie der zweiten Außenumgebung eine elektrische Energie erzeugt, um das elektronische Bauelement mit elektrischer Energie zu versorgen.

Fig. 8 zeigt ein Ablaufdiagramm eines Ausführungsbeispiels eines Verfahrens 800 zum Herstellen eines elektronischen Moduls. In einem Schritt 805 erfolgt das Bilden eines Gehäuses, das zumindest eine erste thermische Leitung und zumindest eine zweite thermische Leitung aufweist. Hierbei erfolgt das Bilden derart, dass die erste thermische Leitung zumindest teilweise entlang einer ersten Oberfläche des Gehäuses verläuft, um eine thermische Energie einer ersten Außenumgebung des Gehäuses aufzunehmen, und die zweite thermische Leitung zumindest teilweise entlang einer zweiten Oberfläche des Gehäuses verläuft, um eine thermische Energie einer von der ersten Außenumgebung thermisch getrennten zweiten Außenumgebung aufzunehmen.

In einem Schritt 810 erfolgt ferner das Anordnen zumindest eines elektronischen Bauelements und zumindest einer Energieversorgungseinheit in und/oder an dem Gehäuse. Hierbei erfolgt das Anordnen derart, dass die Energieversorgungseinheit mit dem elektronischen Bauelement, der ersten thermischen Leitung und der zweiten thermischen Leitung verbunden wird, wobei die Energieversorgungseinheit ausgebildet ist, um unter Verwendung der thermischen Energie der ersten Außenumgebung und der thermischen Energie der zweiten Außenumgebung eine elektrische Energie zu erzeugen.

Die beschriebenen und in den Figuren gezeigten Ausführungsbeispiele sind nur beispielhaft gewählt. Unterschiedliche Ausführungsbeispiele können vollständig oder in Bezug auf einzelne Merkmale miteinander kombiniert werden. Auch kann ein Ausführungsbeispiel durch Merkmale eines weiteren Ausführungsbeispiels ergänzt werden.

Ferner können die hier vorgestellten Verfahrensschritte wiederholt sowie in einer anderen als in der beschriebenen Reihenfolge ausgeführt werden.

Umfasst ein Ausführungsbeispiel eine "und/oder"-Verknüpfung zwischen einem ersten Merkmal und einem zweiten Merkmal, so ist dies so zu lesen, dass das Ausführungsbeispiel gemäß einer Ausführungsform sowohl das erste Merkmal als auch das zweite Merkmal und gemäß einer weiteren Ausführungsform entweder nur das erste Merkmal oder nur das zweite Merkmal aufweist.

## Patentansprüche

1. Elektronisches Modul (100) mit folgenden Merkmalen:
einem Gehäuse (105), das zumindest eine erste thermische Leitung (120) und zumindest eine zweite thermische Leitung (125) aufweist, wobei die erste thermische Leitung (120) zumindest teilweise entlang einer ersten Oberfläche (130) des Gehäuses (105) verläuft, um eine thermische Energie einer ersten Außenumgebung (T1) des Gehäuses (105) aufzunehmen, wobei die zweite thermische Leitung (125) zumindest teilweise entlang einer zweiten Oberfläche (135) des Gehäuses (105) verläuft, um eine thermische Energie einer von der ersten Außenumgebung (T1) thermisch getrennten zweiten Außenumgebung (T2) aufzunehmen;
zumindest einem elektronischen Bauelement (110); und
zumindest einer in und/oder an dem Gehäuse (105) angeordnete Energieversorgungseinheit (115), die mit dem elektronischen Bauelement (110), insbesondere über zumindest einen Schaltkreis, der ersten thermischen Leitung (120) und der zweiten thermischen Leitung (125) verbunden ist und ausgebildet ist, um unter Verwendung der thermischen Energie der ersten Außenumgebung (T1) und der thermischen Energie der zweiten Außenumgebung (T2) eine elektrische Energie zu erzeugen, um das zumindest eine elektronische Bauelement (110) zu betreiben.

2. Elektronisches Modul (100) gemäß Anspruch 1, **dadurch gekennzeichnet, dass** das Gehäuse (105) derart ausgestaltet ist, dass die erste Oberfläche (130) der zweiten Oberfläche (135) gegenüberliegt.

3. Elektronisches Modul (100) gemäß einem der vorangegangenen Ansprüche, **gekennzeichnet durch** zumindest eine mit dem elektronischen Bauelement (110) über zumindest einen Schaltkreis und/oder zumindest eine elektronische Komponente verbundene Fotovoltaikzelle (205), die derart in und/oder an dem Gehäuse (105) angeordnet ist, dass die erste Oberfläche (130) und/oder die zweite Oberfläche (130) zumindest teilweise durch eine Oberfläche der Fotovoltaikzelle (205) gebildet ist.

4. Elektronisches Modul (100) gemäß Anspruch 3, **dadurch gekennzeichnet, dass** die erste thermische Leitung (120) und/oder die zweite thermische Leitung (125) zumindest teilweise zwischen der Fotovoltaikzelle (205) und dem Gehäuse (105), insbesondere zumindest teilweise an der Rückseite der Fotovoltaikzelle (205) verläuft.

5. Elektronisches Modul (105) gemäß einem der vorangegangenen Ansprüche, **gekennzeichnet durch** ein Energiespeicherzellengehäuse (210) zum Aufnehmen zumindest einer Energiespeicherzelle (215) zur Energiebereitstellung zur Versorgung und/oder Unterstützung des elektronischen Bauelements (110).

6. Elektronisches Modul (100) gemäß Anspruch 5, **dadurch gekennzeichnet, dass** das Energiespeicherzellengehäuse (210) eine thermisch leitfähige Struktur (220) zum Aufnehmen der thermischen Energie der ersten Außenumgebung (T1) und/oder der thermischen Energie der zweiten Außenumgebung (T2) aufweist, wobei das Energiespeicherzellengehäuse (210) derart an der ersten Oberfläche (130) und/oder der zweiten Oberfläche (135) des Gehäuses (105) angeordnet oder anordenbar ist, dass die thermisch leitfähige Struktur (220) mit der ersten thermischen Leitung (120) und/oder der zweiten thermischen Leitung (125) thermisch leitfähig verbunden ist.

7. Elektronisches Modul (100) gemäß Anspruch 5 oder 6, **dadurch gekennzeichnet, dass** insbesondere in Teilbereichen das Energiespeicherzellengehäuse (210) eine Antennenstruktur (245) zum Vergrößern einer Länge einer in und/oder an dem Gehäuse (105) angeordneten Funkkomponente (240), insbesondere einer Antenne, aufweist.

8. Elektronisches Modul (100) gemäß einem der vorangegangenen Ansprüche, **dadurch gekennzeichnet, dass** das elektronische Bauelement (110) als Sensorelement ausgebildet ist.

9. Elektronisches Modul (100) gemäß einem der vorangegangenen Ansprüche, **dadurch gekennzeichnet, dass** das elektronische Bauelement (110) in einem Hohlraum (225) des Gehäuses (105) angeordnet oder anordenbar ist, insbesondere wobei zumindest ein Kanal (400) in dem Gehäuse (105) ausgebildet ist, um den Hohlraum (225) mit der ersten Außenumgebung (T1) und/oder der zweiten Außenumgebung (T2) fluidisch zu verbinden.

10. Elektronisches Modul (100) gemäß einem der vorangegangenen Ansprüche, **dadurch gekennzeichnet, dass** das Gehäuse (105) derart in und/oder an einer Scheibe (600) und/oder einem Rahmen (615) eines Fensters (610), und/oder einer Tür und /oder einer Wand angeordnet oder anordenbar ist, dass die erste Oberfläche (130) des Gehäuses (105) einer der ersten Außenumgebung (T1) zugewandten Hauptoberfläche des Fensters (610) zugewandt ist und die zweite Oberfläche (135) des Gehäuses (105) einer der zweiten Außenumgebung (T2) zugewandten Hauptoberfläche des Fensters (610) zugewandt ist.

11. Verfahren (700) zum Betreiben eines elektronischen Moduls (100) gemäß einem der vorangegangenen Ansprüche, wobei das Verfahren (700) folgende Schritte umfasst:
Leiten (705) einer thermischen Energie der ersten Außenumgebung (T1) über die erste thermische Leitung (120) zu der Energieversorgungseinheit (115) und einer thermischen Energie der zweiten Außenumgebung (T2) über die zweite thermische Leitung (125) zu der Energieversorgungseinheit (115); und
Erzeugen (710) einer elektrischen Energie unter Verwendung der thermischen Energie der ersten Außenumgebung (T1) und der thermischen Energie der zweiten Außenumgebung (T2), um das elektronische Bauelement (110) mit elektrischer Energie zu versorgen.

12. Verfahren (800) zum Herstellen eines elektronischen Moduls (100) gemäß einem der vorangegangenen Ansprüche, wobei das Verfahren (800) folgende Schritte umfasst:
Bilden (805) eines Gehäuses (105), das zumindest eine erste thermische Leitung (120) und zumindest eine zweite thermische Leitung (125) aufweist, wobei das Bilden (805) derart erfolgt, dass die erste thermische Leitung (120) zumindest teilweise entlang einer ersten Oberfläche (130) des Gehäuses (105) verläuft, um eine thermische Energie einer ersten Außenumgebung (T1) des Gehäuses (105) aufzunehmen, und die zweite thermische Leitung (125) zumindest teilweise entlang einer zweiten Oberfläche (135) des Gehäuses (105) verläuft, um eine thermische Energie einer von der ersten Außenumgebung (T1) thermisch getrennten zweiten Außenumgebung (T2) aufzunehmen; und
Anordnen (810) zumindest eines elektronischen Bauelements (110) und zumindest einer Energieversorgungseinheit (115) in und/oder an dem Gehäuse (105), wobei das Anordnen (810) derart erfolgt, dass die Energieversorgungseinheit (115) mit dem elektronischen Bauelement (110) insbesondere über zumindest einen Schaltkreis, der ersten thermischen Leitung (120) und der zweiten thermischen Leitung (125) verbunden wird, wobei die Energieversorgungseinheit (115) ausgebildet ist, um unter Verwendung der thermischen Energie der ersten Außenumgebung (T1) und der thermischen Energie der zweiten Außenumgebung (T2) eine elektrische Energie zu erzeugen, um das zumindest ein elektronische Bauelement (110) zu betreiben.

13. Computerprogrammprodukt mit Programmcode zur Durchführung des Verfahrens (700, 800) gemäß Anspruch 11 oder 12, wenn das Computerprogrammprodukt auf einer Vorrichtung ausgeführt wird.

## Claims

1. Electronic module (100) having the following features:
a housing (105), which has at least one first thermal line (120) and at least one second thermal line (125), wherein the first thermal line (120) runs at least partly along a first surface (130) of the housing (105), in order to absorb thermal energy from a first external environment (T1) of the housing (105), wherein the second thermal line (125) runs at least partly along a second surface (135) of the housing (105), in order to absorb thermal energy from a second external environment (T2) that is thermally insulated from the first external environment (T1);
at least one electronic component (110); and
at least one energy supply unit (115) arranged in and/or on the housing (105), said energy supply unit being connected to the electronic component (110), in particular by means of at least one circuit, to the first thermal line (120) and to the second thermal line (125) and being configured to generate electrical energy using the thermal energy from the first external environment (T1) and the thermal energy from the second external environment (T2), in order to operate the at least one electronic component (110).

2. Electronic module (100) according to Claim 1, **characterized in that** the housing (105) is designed in such a way that the first surface (130) lies opposite the second surface (135).

3. Electronic module (100) according to either of the preceding claims, **characterized by** at least one photovoltaic cell (205) connected to the electronic component (110) by means of at least one circuit and/or at least one electronic component part, said photovoltaic cell being arranged in and/or on the housing (105) in such a way that the first surface (130) and/or the second surface (130) is at least partly formed by a surface of the photovoltaic cell (205).

4. Electronic module (100) according to Claim 3, **characterized in that** the first thermal line (120) and/or the second thermal line (125) runs at least partly between the photovoltaic cell (205) and the housing (105), in particular at least partly on the rear side of the photovoltaic cell (205).

5. Electronic module (105) according to one of the preceding claims, **characterized by** an energy storage cell housing (210) for accommodating at least one energy storage cell (215) for providing energy for supplying power to and/or supporting the electronic component (110).

6. Electronic module (100) according to Claim 5, **characterized in that** the energy storage cell housing (210) has a thermally conductive structure (220) for absorbing the thermal energy from the first external environment (T1) and/or the thermal energy from the second external environment (T2), wherein the energy storage cell housing (210) is arranged or can be arranged on the first surface (130) and/or the second surface (135) of the housing (105) in such a way that the thermally conductive structure (220) is thermally conductively connected to the first thermal line (120) and/or to the second thermal line (125).

7. Electronic module (100) according to Claim 5 or 6, **characterized in that**, particularly in subregions, the energy storage cell housing (210) has an antenna structure (245) for increasing a length of a radio component part (240), in particular an antenna, arranged in and/or on the housing (105).

8. Electronic module (100) according to one of the preceding claims, **characterized in that** the electronic component (110) is configured as a sensor element.

9. Electronic module (100) according to one of the preceding claims, **characterized in that** the electronic component (110) is arranged or can be arranged in a cavity (225) of the housing (105), in particular wherein at least one channel (400) is formed in the housing (105), in order to fluidically connect the cavity (225) to the first external environment (T1) and/or the second external environment (T2).

10. Electronic module (100) according to one of the preceding claims, **characterized in that** the housing (105) is arranged or can be arranged in and/or on a windowpane (600) and/or a frame (615) of a window (610) and/or a door and/or a wall in such a way that the first surface (130) of the housing (105) faces a main surface of the window (610) that faces the first external environment (T1) and the second surface (135) of the housing (105) faces a main surface of the window (610) that faces the second external environment (T2).

11. Method (700) for operating an electronic module (100) according to one of the preceding claims, wherein the method (700) comprises the following steps:
conducting (705) thermal energy from the first external environment (T1) via the first thermal line (120) to the energy supply unit (115) and thermal energy from the second external environment (T2) via the second thermal line (125) to the energy supply unit (115); and
generating (710) electrical energy using the thermal energy from the first external environment (T1) and the thermal energy from the second external environment (T2), in order to supply the electronic component (110) with electrical energy.

12. Method (800) for producing an electronic module (100) according to one of the preceding claims, wherein the method (800) comprises the following steps:
forming (805) a housing (105), which has at least one first thermal line (120) and at least one second thermal line (125), wherein the forming (805) is effected in such a way that the first thermal line (120) runs at least partly along a first surface (130) of the housing (105), in order to absorb thermal energy from a first external environment (T1) of the housing (105), and the second thermal line (125) runs at least partly along a second surface (135) of the housing (105), in order to absorb thermal energy from a second external environment (T2) that is thermally insulated from the first external environment (T1); and
arranging (810) at least one electronic component (110) and at least one energy supply unit (115) in and/or on the housing (105), wherein the arranging (810) is effected in such a way that the energy supply unit (115) is connected to the electronic component (110), in particular by means of at least one circuit, to the first thermal line (120) and to the second thermal line (125), wherein the energy supply unit (115) is configured to generate electrical energy using the thermal energy from the first external environment (T1) and the thermal energy from the second external environment (T2), in order to operate the at least one electronic component (110).

13. Computer program product having program code for carrying out the method (700, 800) according to Claim 11 or 12 when the computer program product is run on a device.

## Revendications

1. Module électronique (100) présentant les éléments caractéristiques suivantes :
un boîtier (105) qui comporte au moins une première ligne de conduction thermique (120) et au moins une deuxième ligne de conduction thermique (125), dans lequel la première ligne de conduction thermique (120) s'étend au moins partiellement le long d'une première surface (130) du boîtier (105), pour absorber une énergie thermique d'un premier environnement extérieur (T1) du boîtier (105), dans lequel la deuxième ligne de conduction thermique (125) s'étend au moins partiellement le long d'une deuxième surface (135) du boîtier (105), pour absorber une énergie thermique d'un deuxième environnement extérieur (T2) thermiquement séparé du premier environnement extérieur (T1) ;
au moins un composant électronique (110) ; et
au moins une unité d'alimentation en énergie (115) disposée dans et/ou sur le boîtier (105), qui est reliée au composant électronique (110), notamment par l'intermédiaire d'au moins un circuit, à la première ligne de conduction thermique (120) et à la deuxième ligne de conduction thermique (125) et est conçu pour générer une énergie électrique, par utilisation de l'énergie thermique du premier environnement extérieur (T1) et de l'énergie thermique du deuxième environnement extérieur (T2), afin de faire fonctionner l'au moins un composant électronique (110).

2. Module électronique (100) selon la revendication 1, **caractérisé en ce que** le boîtier (105) est conçu de manière à ce que la première surface (130) soit opposée à la deuxième surface (135).

3. Module électronique (100) selon l'une quelconque des revendications précédentes, **caractérisé par** au moins une cellule photovoltaïque (205) reliée au composant électronique (110) par l'intermédiaire d'au moins un circuit et/ou d'au moins un composant électronique, qui est disposé dans et/ou sur le boîtier (105) de manière à ce que la première surface (130) et/ou la deuxième surface (130) soit formée au moins partiellement par une surface de la cellule photovoltaïque (205).

4. Module électronique (100) selon la revendication 3, **caractérisé en ce que** la première ligne de conduction thermique (120) et/ou la deuxième ligne de conduction thermique (125) s'étend au moins partiellement entre la cellule photovoltaïque (205) et le boîtier (105), et s'étend notamment au moins partiellement sur la face arrière de la cellule photovoltaïque (205).

5. Module électronique (105) selon l'une quelconque des revendications précédentes, **caractérisé par** un boîtier de cellule accumulatrice d'énergie (210) destiné au logement d'au moins une cellule accumulatrice d'énergie (215) permettant de fournir de l'énergie pour l'alimentation et/ou la prise en charge du composant électronique (110).

6. Module électronique (100) selon la revendication 5, **caractérisé en ce que** le boîtier de cellule accumulatrice d'énergie (210) présente une structure thermiquement conductrice (220) destinée à absorber l'énergie thermique du premier environnement extérieur (T1) et/ou l'énergie thermique du deuxième environnement extérieur (T2), dans lequel le boîtier de cellule accumulatrice d'énergie (210) est disposé ou peut être disposé sur la première surface (130) et/ou sur la deuxième surface (135) du boîtier (105) de manière à ce que la structure thermiquement conductrice (220) soit reliée de manière thermiquement conductrice à la première ligne de conduction thermique (120) et/ou à la deuxième ligne de conduction thermique (125).

7. Module électronique (100) selon la revendication 5 ou 6, **caractérisé en ce que** le boîtier de cellule accumulatrice d'énergie (210) comporte, notamment dans certaines sections, une structure d'antenne (245) destinée à augmenter une longueur d'un composant radio (240), notamment d'une antenne, disposée dans et/ou sur le boîtier (105).

8. Module électronique (100) selon l'une quelconque des revendications précédentes, **caractérisé en ce que** le composant électronique (110) est réalisé sous la forme d'un élément de détection.

9. Module électronique (100) selon l'une quelconque des revendications précédentes, **caractérisé en ce que** le composant électronique (110) est disposé ou peut être disposé dans une cavité (225) du boîtier (105), notamment dans lequel au moins un canal (400) est réalisé dans le boîtier (105), pour relier de manière fluidique la cavité (225) au premier environnement extérieur (T1) et/ou au deuxième environnement extérieur (T2).

10. Module électronique (100) selon l'une quelconque des revendications précédentes, **caractérisé en ce que** le boîtier (105) est disposé ou peut être disposé dans et/ou sur une plaque (600) et/ou sur un cadre (615) d'une fenêtre (610), et/ou sur une porte et/ou sur un mur, de manière à ce que la première surface (130) du boîtier (105) soit tournée vers une surface principale de la fenêtre (610) tournée vers le premier environnement extérieur (T1) et à ce que la deuxième surface (135) du boîtier (105) soit tournée vers une surface principale de la fenêtre (610) tournée vers le deuxième environnement extérieur (T2).

11. Procédé (700) de mise en fonctionnement d'un module électronique (100) selon l'une quelconque des revendications précédentes, dans lequel le procédé (700) comprend les étapes consistant à :
acheminer (705) une énergie thermique du premier environnement extérieur (T1), par l'intermédiaire de la première ligne de conduction thermique (120), vers l'unité d'alimentation en énergie (115), et une énergie thermique du deuxième environnement extérieur (T2), par l'intermédiaire de la deuxième ligne de conduction thermique (125), vers l'unité d'alimentation en énergie (115) ; et
générer (710) une énergie électrique par utilisation de l'énergie thermique du premier environnement extérieur (T1) et de l'énergie thermique du deuxième environnement extérieur (T2), pour l'alimentation en énergie électrique du composant électronique (110).

12. Procédé (800) de fabrication d'un module électronique (100) selon l'une quelconque des revendications précédentes, dans lequel le procédé (800) comprend les étapes consistant à :
former (805) un boîtier (105) qui comporte au moins une première ligne de conduction thermique (120) et au moins une deuxième ligne de conduction thermique (125), dans lequel ladite formation (805) s'effectue de manière à ce que la première ligne de conduction thermique (120) s'étende au moins partiellement le long d'une première surface (130) du boîtier (105), pour absorber une énergie thermique d'un premier environnement extérieur (T1) du boîtier (105), et à ce que la deuxième ligne de conduction thermique (125) s'étende au moins partiellement le long d'une deuxième surface (135) du boîtier (105), pour absorber une énergie thermique d'un deuxième environnement extérieur (T2) thermiquement séparé du premier environnement extérieur (T1) ; et
agencer (810) au moins un composant électronique (110) et au moins une unité d'alimentation en énergie (115) dans et/ou sur le boîtier (105), dans lequel l'agencement (810) s'effectue de manière à ce que l'unité d'alimentation en énergie (115) soit reliée au composant électronique (110), notamment par l'intermédiaire d'au moins un circuit, à la première ligne de conduction thermique (120) et à la deuxième ligne de conduction thermique (125), dans lequel l'unité d'alimentation en énergie (115) est réalisée de manière à générer une énergie électrique par utilisation de l'énergie thermique du premier environnement extérieur (T1) et de l'énergie thermique du deuxième environnement extérieur (T2), afin de faire fonctionner l'au moins un composant électronique (110).

13. Produit de programme d'ordinateur comportant un code de programme destiné à mettre en oeuvre le procédé (700, 800) selon la revendication 11 ou 12 lorsque le produit de programme d'ordinateur est exécuté sur un dispositif.
